# EUROPÄISCHE PATENTSCHRIFT

(11) **EP 4 337 967 B1**
(45) Veröffentlichungstag und Bekanntmachung des Hinweises auf die Patenterteilung: **10.09.2025**
(21) Anmeldenummer: 22744224.1
(22) Anmeldetag: 20.07.2022
(51) Int. Cl.: G01R 1/20

(54) **STROMMESSWIDERSTAND**
CURRENT MEASURING RESISTOR
RÉSISTANCE DE MESURE DE COURANT

(30) Priorität: 31.08.2021 DE 102021122491
(43) Veröffentlichungstag der Anmeldung: 20.03.2024
(73) Patentinhaber: Isabellenhütte Heusler GmbH & Co. KG, 35683 Dillenburg (DE)
(72) Erfinder: HARTMANN, Jens, 35713 Eschenburg (DE); LAUFER, Andreas, 35444 35444 Biebertal (DE); KRAMM, Benedikt, 35435 Wettenberg (DE); MARIEN, Jan, 35745 Herborn (DE)
(74) Vertreter: v. Bezold & Partner Patentanwälte - PartG mbB
(86) Internationale Anmeldenummer: PCT/EP2022/070407
(87) Internationale Veröffentlichungsnummer: WO 2023/030750

(56) Entgegenhaltungen:
- US-A1- 2002 171 987
- US-A1- 2013 181 807
- US-B1- 6 801 118

## Beschreibung

### Technisches Gebiet der Erfindung

Die Erfindung betrifft einen Strommesswiderstand zur Messung eines elektrischen Stroms. Weiterhin betrifft die Erfindung eine Leiterplattenanordnung mit einer Leiterplatte und einem solchen Strommesswiderstand.

### Hintergrund der Erfindung

Aus dem Stand der Technik (z.B. EP 0 605 800 A1) sind niederohmige Strommesswiderstände ("Shunts") bekannt, die eine Strommessung gemäß der Vierleitertechnik ermöglichen. Hierbei wird der zu messende elektrische Strom durch den niederohmigen Strommesswiderstand geleitet, wobei der Spannungsabfall über dem Strommesswiderstand gemessen wird. Der gemessene Spannungsabfall ist dann entsprechend dem Ohmschen Gesetz ein Maß für den elektrischen Strom, der durch den niederohmigen Strommesswiderstand fließt.

Derartige niederohmige Strommesswiderstand weisen zwei Anschlussteile aus einem Leitermaterial (z.B. Kupfer) auf, um den elektrischen Strom in den Strommesswiderstand einzuleiten bzw. von dem Strommesswiderstand abzuführen. In Stromflussrichtung zwischen den beiden Anschlussteilen befindet sich ein niederohmiges Widerstandselement aus einem Widerstandsmaterial (z.B. Manganin^{®}), so dass der zu messende elektrische Strom durch das Widerstandselement fließt. Bei der Strommessung wird dann der Spannungsabfall über dem Widerstandselement gemessen. Diese bekannten Strommesswiderstände können beispielsweise mit Stromschienen verschraubt werden, um den zu messende Strom zuzuführen bzw. abzuführen.

Problematisch hierbei kann die Tatsache sein, dass die bekannten Strommesswiderstände starr sind, so dass die Anschlussstellen des Strommesswiderstands keine Relativbewegung zueinander erlauben. Dies ist beispielsweise auch problematisch, wenn sich der Abstand zwischen den Anschlussstellen durch Wärmeausdehnung oder Vibration ändert.

Zum technischen Hintergrund der Erfindung ist auch hinzuweisen auf US 6 801 118 B1 und US 2013/181807 A1.

Schließlich offenbart US 2002/171987 A1 einen Strommesswiderstand gemäß dem Oberbegriff von Anspruch 1. Dieser bekannte Strommesswiderstand ist jedoch noch nicht vollständig befriedigend.

### Beschreibung der Erfindung

Der Erfindung liegt deshalb die Aufgabe zugrunde, einen entsprechend verbesserten Strommesswiderstand zu schaffen.

Diese Aufgabe wird durch einen erfindungsgemäßen Strommesswiderstand gemäß dem Hauptanspruch gelöst.

Der erfindungsgemäße Strommesswiderstand weist zunächst in Übereinstimmung mit dem eingangs beschriebenen bekannten Strommesswiderstand ein erstes Anschlussteil auf, das vorzugsweise aus einem Leitermaterial (z.B. Kupfer, Kupferlegierung, Aluminium, Aluminierlegierung) besteht und dazu dient, den zu messenden elektrischen Strom in den Strommesswiderstand einzuleiten.

Darüber hinaus weist der erfindungsgemäße Strommesswiderstand ein zweites Anschlussteil auf, das vorzugsweise aus einem Leitermaterial (z.B. Kupfer, Kupferlegierung, Aluminium, Aluminierlegierung) besteht, um den zu messenden elektrischen Strom wieder aus dem Strommesswiderstand auszuleiten.

In Stromflussrichtung zwischen den beiden Anschlussteilen ist hierbei ein Widerstandselement angeordnet, das aus einem Widerstandsmaterial (z.B. Manganin^{®}) besteht, so dass der zu messende elektrische Strom bei einer Strommessung durch das Widerstandselement fließt. Dies ermöglicht in bekannter Weise eine Strommessung gemäß der Vierleitertechnik, indem bei der Strommessung der Spannungsabfall über dem Widerstandselement gemessen wird, so dass der gemessene Spannungsabfall entsprechend dem Ohmschen Gesetz ein Maß für den durch den Strommesswiderstand fließenden elektrischen Strom ist.

Hierbei ist zu erwähnen, dass die beiden Anschlussteile nicht notwendigerweise aus demselben Leitermaterial bestehen müssen. Vielmehr besteht im Rahmen der Erfindung auch die Möglichkeit, dass die beiden Anschlussteile aus unterschiedlichen Leitermaterialien bestehen, beispielsweise aus Kupfer oder einer Kupferlegierung einerseits bzw. aus Aluminium oder eine Aluminiumlegierung andererseits.

Weiterhin besteht im Rahmen der Erfindung auch die Möglichkeit, dass die beiden Anschlussteile und das Widerstandselement alle aus demselben Widerstandsmaterial bestehen, so dass der Strommesswiderstand einstückig sein kann.

Vorzugsweise besteht der erfindungsgemäße Strommesswiderstand jedoch aus drei Teilen (Widerstandselement und zwei Anschlussteile), wobei die beiden Anschlussteile aus einem Leitermaterial bestehen, während das Widerstandselement aus einem Widerstandsmaterial besteht.

Der erfindungsgemäße Strommesswiderstand zeichnet sich durch mindestens ein flexibles Verformungselement auf, das es ermöglicht, den Strommesswiderstand zerstörungsfrei und reversibel zu verformen. Dies ermöglicht beispielsweise eine Abstandsänderung zwischen den Anschlussteilen des Strommesswiderstands oder eine Anwinkelung der Anschlussteile relativ zueinander, beispielsweise bei einer Verdrehung und/oder Verbiegung des Strommesswiderstands. Das Verformungselement ist hierbei in Stromflussrichtung zwischen den beiden Anschlussteilen angeordnet, so dass der zu messende elektrische Strom bei der Strommessung durch das Verformungselement fließt.

Hierbei ist zu erwähnen, dass der erfindungsgemäße Strommesswiderstand mehrere Verformungselemente aufweisen kann, die beispielsweise parallel zueinander angeordnet sein können. Beispielsweise können mehrere biegsame Folien als Verformungselemente übereinander angeordnet sein und einen Stapel bilden.

In einem bevorzugten Ausführungsbeispiel der Erfindung wird das Verformungselement durch das Widerstandselement gebildet, d.h. das Verformungselement und das Widerstandselement sind hierbei identisch. Es besteht jedoch alternativ auch die Möglichkeit, dass das Verformungselement einerseits und das Widerstandselement andererseits getrennte Bauteile sind, die in Stromflussrichtung hintereinander angeordnet sind.

Weiterhin ist zu erwähnen, dass das Verformungselement wahlweise elastisch oder plastisch verformbar sein kann.

Das Verformungselement sollte jedoch eine zerstörungsfreie Längenänderung des Strommesswiderstands von mindestens 10 %, 20 %, 30%, 50%, 80% oder 100% ermöglichen, wobei die Längenänderung auf die Stromflussrichtung oder auf den kürzesten Abstand zwischen den Kontaktierungsstellen für die Einleitung bzw. Ausleitung des Stroms bezogen sein kann.

Weiterhin ist zu erwähnen, dass das Verformungselement vorzugsweise eine zerstörungsfreie Verbiegung der Anschlussteile relativ zueinander von mindestens 10°, 20°, 40°, 80°, 90°, 100°, 135° 160° oder 180° ermöglicht, wobei der Verbiegungswinkel bei plattenförmigen Anschlussteilen auf die Plattenebene der Anschlussteile bezogen ist.

Darüber hinaus kann das Verformungselement eine zerstörungsfreie Verdrehung der Anschlussteile relativ zueinander ermöglichen mit einem Verdrehwinkel von 10°, 20°, 40°, 80° oder sogar 90°, wobei der Verdrehwinkel vorzugsweise auf die Stromflussrichtung in dem Strommesswiderstand bezogen ist.

Das Verformungselement kann jedoch verschiedene Arten der Verformung ermöglichen, wie beispielsweise eine kombinierte Verbiegung und Verdrehung.

Beispielsweise kann das Verformungselement als Folienstapel oder Bandstapel ausgebildet sein, um nur einige Beispiele zu nennen.

Erfindungsgemäß ist das Verformungselement als Stapel ausgebildet, insbesondere mit einer Verbindung mit den Anschlussteilen durch Pressen, Schweißen, Nieten oder Crimpen.

In einem erfindungsgemäßen Ausführungsbeispiel ist das Verformungselement nicht direkt mit den eigentlichen Anschlussteilen verbunden, sondern indirekt über mechanische Verbindungselemente. Die Verbindungselemente sind also einerseits mit den Anschlussteilen und andererseits mit dem Verformungselement verbunden. Hierbei können die eigentlichen Anschlussteile die Verbindungselemente einschließen, abdecken oder ummanteln, so dass der Verbindungsbereich auch einen elektrischen Kontaktierungsbereich bildet. Alternativ besteht die Möglichkeit, dass die Anschlussteile räumlich getrennt von den Verbindungselementen sind, so dass der Verbindungsbereich getrennt von dem Kontaktierungsbereich ist.

Hinsichtlich der mechanischen Verbindung zwischen dem Verformungselement einerseits und den Anschlussteilen bzw. den Verbindungselementen andererseits bestehen im Rahmen der Erfindung vielfältige Möglichkeiten. Beispielsweise kann diese Verbindung eine Pressverbindung, eine Schweißverbindung, eine Nietverbindung oder eine Crimp-Verbindung sein, um nur einige Beispiele zu nennen.

Es wurde bereits vorstehend kurz erwähnt, dass der erfindungsgemäße Strommesswiderstand eine Strommessung gemäß der Vierleitertechnik ermöglicht. Hierzu kann der Strommesswiderstand integrierte Spannungsabgriffe aufweisen, die an dem ersten bzw. zweiten Anschlussteil und/oder alternativ an dem Widerstandselement angebracht sind. Der Spannungsabfall zwischen den beiden Spannungsabgriffen bildet dann gemäß dem Ohmschen Gesetz ein Maß für den elektrischen Strom, der durch den Strommesswiderstand fließt.

Beispielsweise können die Spannungsabgriffe an den Anschlussteilen oder dem Widerstandselement jeweils durch einen Pin (Kontaktstift) gebildet werden. Diese Pins können beispielsweise in Bohrungen in den Anschlussteilen bzw. in dem Widerstandselement eingepresst oder auf die Anschlussteile bzw. auf das Widerstandselement aufgeschweißt oder aufgelötet werden. Hierbei ist zu erwähnen, dass die Pins der Spannungsabgriffe aus dem Leitermaterial der Anschlussteile oder aus dem Widerstandsmaterial des Widerstandselements bestehen können. Ferner ist zu erwähnen, dass die Pins der Spannungsabgriffe mit einer Beschichtung versehen sein können, beispielsweise mit einer Beschichtung aus Zinn oder Silber.

Zur Beeinflussung des Stromverlaufs in dem Strommesswiderstand können in den beiden Anschlussteilen Stromschatten in Form jeweils eines Einschnittes vorgesehen sein, wobei sich diese Einschnitte vorzugsweise über die gesamte Dicke der Anschlussteile erstrecken.

Hierbei ist zu erwähnen, dass die Stromschatten in den Anschlussteilen die Spannungsabgriffe vorzugsweise mindestens teilweise umgeben. Beispielsweise können die Stromschatten hierzu L-förmig, U-förmig, C-förmig, V-förmig, gerade oder bogenförmig (z.B. kreisbogenförmig) sein, um nur einige mögliche Formgestaltungen zu nennen.

Allgemein ist zu erwähnen, dass die Stromschatten in den Anschlussteilen die gleiche Form haben können. Es besteht jedoch alternativ auch die Möglichkeit, dass die Stromschatten in den beiden Anschlussteilen unterschiedliche Formen haben.

Weiterhin ist zu bemerken, dass die Stromschatten in den beiden Anschlussteilen wahlweise die gleiche oder eine unterschiedliche Länge haben können, wobei die Länge entlang dem Einschnitt gemessen wird.

Hinsichtlich der räumlichen Anordnung der Stromschatten in dem Strommesswiderstand bestehen im Rahmen der Erfindung ebenfalls verschiedene Möglichkeiten. **In** einem bevorzugten Ausführungsbeispiel der Erfindung gehen die Stromschatten vom Rand des Strommesswiderstands aus und erstrecken sich quer zur Stromflussrichtung nach innen. Es besteht jedoch alternativ auch die Möglichkeit, dass die Stromschatten vom Rand des Stromesswiderstands beabstandet sind.

Ferner ist auch zu erwähnen, dass die Stromschatten wahlweise denselben Abstand oder unterschiedliche Abstände vom seitlichen Rand des Strommesswiderstands haben können. Der seitliche Rand des Strommesswiderstands ist hierbei der Rand des Strommesswiderstands, der parallel zur Hauptstromflussrichtung in dem Stromesswiderstand verläuft.

Darüber hinaus kann auch in dem Widerstandselement ein Stromschatten in Form eines Einschnitts angeordnet sein, um den Stromverlauf in dem Widerstandselement zu beeinflussen. Auch hierbei kann der Stromschatten in dem Widerstandselement vom seitlichen Rand des Widerstandselements ausgehen oder beabstandet zu den Seitenrändern des Strommesswiderstands sein. Hierbei ist jedoch zu erwähnen, dass der Stromschatten in dem Widerstandselement vorzugsweise mittig zwischen den beiden Anschlussteilen angeordnet ist.

Weiterhin besteht im Rahmen der Erfindung die Möglichkeit, dass in das Widerstandselement oder in die Verbindungselemente ein Trimmschnitt eingebracht ist, um den Widerstandswert des Strommesswiderstands zu justieren. Beispielsweise kann dieser Trimmschnitt durch Stanzen, Fräsen, Bohren, Schleifen oder Lasern eingebracht werden.

Hinsichtlich der räumlichen Anordnung des Trimmschnitts in dem Strommesswiderstand bestehen im Rahmen der Erfindung verschiedene Möglichkeiten. Beispielsweise kann der Trimmschnitt am Rand des Strommesswiderstands angeordnet sein oder beabstandet zu den Rändern in der Fläche des Strommesswiderstands.

Bei dem erfindungsgemäßen Stapel können der Trimmschnitt und die Stromschatten in einer Ebene des Stapels, in mehreren Ebenen des Stapels oder in allen Ebenen des Stapels angeordnet sein.

Es wurde vorstehend bereits erwähnt, dass die Spannungsabgriffe an dem Stromesswiderstand als Pins (Kontaktstifte) ausgebildet sein können. Alternativ besteht jedoch auch die Möglichkeit, dass die Spannungsabgriffe jeweils durch Kontakt-Inseln auf den Anschlussteilen oder dem Widerstandselement gebildet werden.

Ferner besteht auch die Möglichkeit, dass die Spannungsabgriffe durch Gegenkontaktierungsflächen gebildet werden, die mit den Anschlussteilen oder dem Widerstandselement in Kontakt stehen, wobei sich diese Gegenkontaktierungsflächen optional auf einer Leiterplatte befinden.

Es wurde vorstehend bereits erwähnt, dass es sich bei dem Leitermaterial der Anschlussteile um Kupfer, eine Kupferlegierung, Aluminium oder eine Aluminiumlegierung handeln kann. Die Erfindung ist jedoch hinsichtlich des Leitermaterials der Anschlussteile nicht auf diese beispielhaft genannten Materialien beschränkt.

Bei dem Widerstandsmaterial des Widerstandselements kann es sich beispielsweise um eine Kupfer-Legierung handeln, wie beispielsweise eine Kupfer-Mangan-Zinn-Legierung (z.B. CuMn12Ni2 oder CuMn7Sn2,3). Alternativ kann es sich bei dem Widerstandsmaterial um eine Kupfer-Mangan-Nickel-Legierung (z.B. Cu84Ni4Mn12 oder Cu65Mn25Ni10) handeln. Ferner besteht auch die Möglichkeit, dass es sich bei dem Widerstandsmaterial um eine Kupfer-Chrom-Legierung oder um eine Nickel-Legierung handelt, wie beispielsweise Nickel-Chrom (z.B. NiCr20AlSi oder CuMnNi).

Allgemein ist zu erwähnen, dass das Leitermaterial der Anschlussteile einen kleineren spezifischen elektrischen Widerstand aufweisen sollte als das Widerstandsmaterial des Widerstandselements, d.h. die Anschlussteile sollten niederohmiger sein als das Widerstandselement.

Das Widerstandsmaterial des Widerstandselements weist deshalb vorzugsweise einen geringen spezifischen elektrischen Widerstand auf, der vorzugsweise kleiner ist als 2·10⁻⁴ Ω·m, 2·10⁻⁵ Ω·m oder 2·10⁻⁶ Ω·m. Der spezifische elektrische Widerstand des Widerstandsmaterials des Widerstandselements ist jedoch vorzugsweise größer 2·10⁻⁶ Ω·m oder 2·10⁻⁷.

Das Leitermaterial der Anschlussteile weist dagegen vorzugsweise einen spezifischen elektrischen Widerstand auf, der kleiner ist als 10⁻⁶ Ω·m oder 10⁻⁷ Ω·m.

Hinsichtlich der Temperaturstabilität ist zu erwähnen, dass das Widerstandsmaterial des Widerstandselements vorzugsweise einen Temperaturkoeffizienten des elektrischen Widerstands aufweist, der im Temperaturbereich von T1 gleich -20 °C bis +140 °C bezogen auf eine Referenztemperatur TRef=20 °C kleiner ist als 50 ppm/K.

Ferner ist auch zu erwähnen, dass die Anschlussteile mit einer Beschichtung beschichtet sein können, die beispielsweise aus Nickel, einer Nickellegierung, Zinn oder einer Zinnlegierung bestehen kann, um nur einige Beispiele zu nennen.

Weiterhin ist allgemein zu erwähnen, dass die Anschlussteile und/oder das Widerstandselement plattenförmig sein können, wobei die Anschlussteile und das Widerstandselement wahlweise eben oder gebogen sein können.

Allgemein ist zu dem Strommesswiderstand noch zu erwähnen, dass der elektrische Widerstandswert des Strommesswiderstands vorzugsweise höchstens 10 mΩ, 1 mΩ, 100 µΩ oder 10 µΩ beträgt.

Neben dem vorstehend beschriebenen erfindungsgemäßen Strommesswiderstand umfasst die Erfindung auch eine Messanordnung mit einem erfindungsgemäßen Strommesswiderstand und einem Kontaktierungspartner (z.B. Leiterplatte, Stanzgitter, Stecker, Pin), wobei mindestens eines der Anschlussteile des Strommesswiderstands elektrisch und mechanisch mit dem Kontaktierungspartner verbunden ist.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert.

### Kurzbeschreibung der Zeichnungen

Figur 1 zeigt eine schematische Darstellung eines erfindungsgemäßen Strommesswiderstands mit einem flexiblen Verbindungselement.
Figur 2 zeigt eine Abwandlung von Figur 1.
Figur 3 zeigt eine Abwandlung der Figuren 1 und 2 mit zwei separaten mechanischen Verbindungselementen zwischen dem Verformungselement und den Anschlussteilen.
Figur 4 zeigt eine Abwandlung der Figuren 1-3 mit Spannungsabgriffen in Form von Pins (Kontaktstiften).
Figur 5 zeigt eine schematische Darstellung einer erfindungsgemäßen Leiterplattenanordnung mit einem erfindungsgemäßen Strommesswiderstand.
Figuren 6-16 zeigen verschiedene schematische Darstellungen von erfindungsgemäßen Strommesswiderständen mit sogenannten Stromschatten in den Anschlussteilen bzw. in dem Widerstandselement.
Figur 17 zeigt eine schematische Darstellung zur Verdeutlichung der möglichen Verbiegung des Strommesswiderstands.
Figur 18 zeigt eine schematische Darstellung zur Verdeutlichung der möglichen Verdrehung des Strommesswiderstands.

### Detaillierte Beschreibung der Zeichnungen

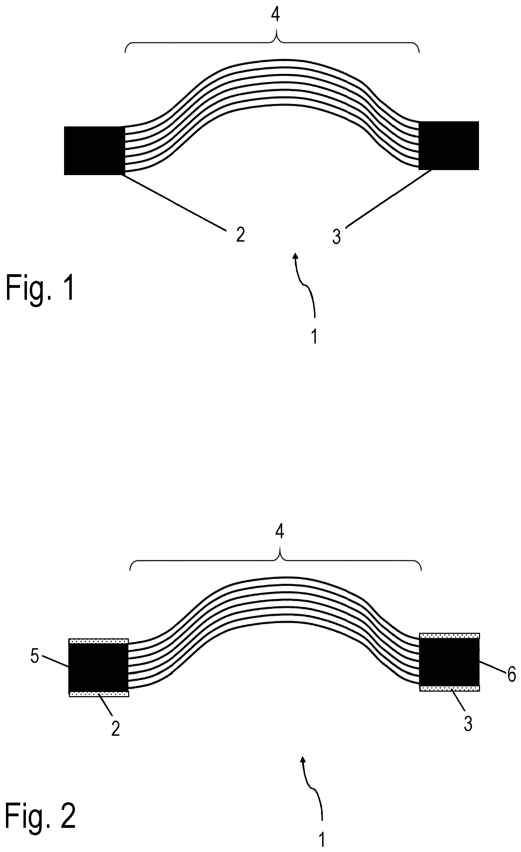

Figur 1 zeigt eine schematische Darstellung eines erfindungsgemäßen Strommesswiderstands 1, der eine Strommessung gemäß der Vierleitertechnik ermöglicht, wie es an sich aus dem Stand der Technik bekannt ist.

Hierzu weist der Strommesswiderstand 1 in diesem Ausführungsbeispiel zwei plattenförmige Anschlussteile 2, 3 auf, die dazu dienen, den zu messenden elektrischen Strom in den Strommesswiderstand 1 einzuleiten bzw. aus dem Strommesswiderstand 1 auszuleiten. Die Anschlussteile 2, 3 bestehen deshalb aus einem niederohmigen Leitermaterial, wie beispielsweise Kupfer, einer Kupferlegierung, Aluminium oder einer Aluminiumlegierung.

In Stromflussrichtung zwischen den beiden Anschlussteilen 2, 3 befindet sich hierbei ein Widerstandselement 4 aus einer Widerstandslegierung, wie beispielsweise Manganin^{®}, um nur ein Beispiel zu nennen.

Bei einer Messung fließt also der zu messende elektrische Strom zwischen den Anschlussteilen 2, 3 durch das Widerstandselement 4. Zur Strommessung wird dann der Spannungsabfall über dem Widerstandselement 4 gemessen, wobei der gemessene Spannungsabfall entsprechend dem Ohmschen Gesetz ein Maß für den elektrischen Strom ist, der durch den Strommesswiderstand 1 fließt.

Eine erfindungsgemäße Besonderheit des Strommesswiderstands 1 besteht darin, dass das Widerstandselement 4 nicht starr ist, wie es bei den eingangs beschriebenen bekannten Strommesswiderstand nun der Fall ist. Vielmehr ist das Widerstandselement 4 hierbei flexibel und bildet somit ein Verformungselement, das es ermöglicht, die Position der Anschlussteile 2, 3 relativ zueinander zu ändern. Das als Verformungselement ausgebildete Widerstandselement 4 ermöglicht also eine mechanische Entkopplung der Anschlussteile 2, 3 relativ zueinander.

In der Zeichnung ist das Widerstandselement 4 nur schematisch dargestellt, um anzudeuten, dass das Widerstandselement 4 flexibel verformbar ist. Erfindungsgemäß ist das Widerstandselement 4 ein Stapel..

Figur 2 zeigt eine Abwandlung des Ausführungsbeispiels gemäß Figur 1, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass zwischen den Anschlussteilen 2, 3 und dem als Verformungselement ausgebildeten Widerstandselement 4 separate mechanische Verbindungselemente 5, 6 angeordnet sind. Die Verbindungselemente 5, 6 sind also einerseits mit dem Widerstandselement 4 und andererseits mit den Anschlussteilen 1, 2 verbunden. Diese Konstruktion ermöglicht eine Homogenisierung der Stromverteilung über den Querschnitt des flexiblen Widerstandselements 4. Die mechanische und elektrische Verbindung kann hierbei durch Verpressen, Verschweißen, Vernieten oder Crimpen erfolgen, um nur einige Beispiele für mögliche Verbindungsarten zu nennen.

In diesem Ausführungsbeispiel umschließen die aus Kupfer bestehenden Anschlussteile 2, 3 die Verbindungselemente 5 bzw. 6, so dass der mechanische Verbindungsbereich auch zum elektrischen Kontaktierungsbereich wird.

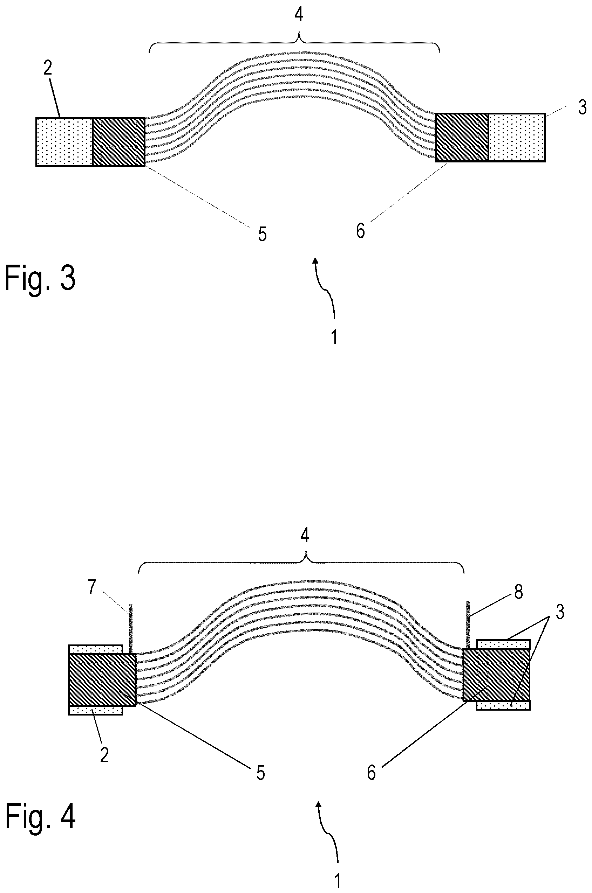

Figur 3 zeigt eine Abwandlung des Ausführungsbeispiels gemäß Figur 2, so dass zur Vermeidung von Wiederholungen auf die vorstehende Beschreibung verwiesen wird, wobei für entsprechende Einzelheiten dieselben Bezugszeichen verwendet werden.

Eine Besonderheit besteht hierbei darin, dass die Anschlussteile 2, 3 außen an den Verbindungselementen 5, 6 angebracht sind, beispielsweise durch eine Schweißverbindung. Der mechanische Verbindungsbereich ist hierbei also räumlich getrennt von dem elektrischen Kontaktierungsbereich.

Figur 4 zeigt eine Abwandlung des Ausführungsbeispiels gemäß Figur 2, so dass zur Vermeidung von Wiederholungen wieder auf die vorstehende Beschreibung verwiesen wird, wobei für entsprechende Einzelheiten dieselben Bezugszeichen verwendet werden.

Eine Besonderheit dieses Ausführungsbeispiels besteht darin, dass an den beiden Verbindungselementen 5, 6 Spannungsabgriffe 7 bzw. 8 angebracht sind, die in diesem Ausführungsbeispiel aus Pins (Kontaktstifte) bestehen. An den beiden Spannungsabgriffen 7, 8 kann der Spannungsabfall über dem Widerstandselement 4 gemessen werden, um gemäß der Vierleitertechnik den elektrischen Strom zu messen, der durch den Strommesswiderstand 1 fließt.

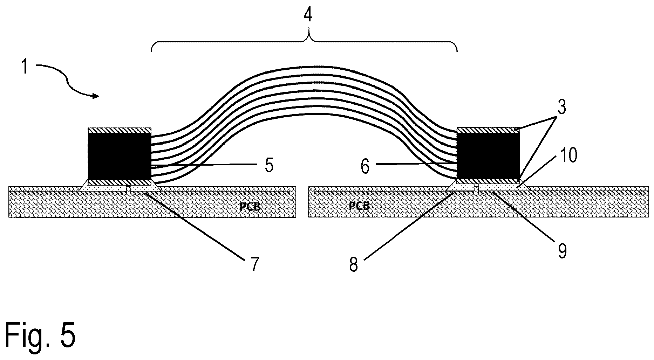

Figur 5 zeigt eine schematische Darstellung einer erfindungsgemäßen Leiterplattenanordnung mit einer Leiterplatte PCB (PCB: Printed Circuit Board), wobei sich auf der Oberseite der Leiterplatte PCB Leiterbahnen 9 und Spannungsabgriffe 7, 8 befinden.

Auf der Oberseite der Leiterplatte PCB ist der erfindungsgemäße Strommesswiderstand 1 angeordnet, wie er vorstehend bereits beschrieben wurde, so dass hierzu auf die vorstehende Beschreibung verwiesen wird.

Das Anschlussteil 3 des Strommesswiderstands 1 ist hierbei über eine Lötverbindung 10 mit der Leiterbahn 9 auf der Leiterplatte PCB elektrisch und mechanisch verbunden.

Darüber hinaus ist das Anschlussteil 3 über eine weitere Lötverbindung mit dem Spannungsabgriff 8 an der Oberseite der Leiterplatte PCB elektrisch und mechanisch verbunden.

Zum einen kann so der zu messende elektrische Strom von der Leiterplatte PCB in den Strommesswiderstand 1 eingespeist werden.

Zum anderen kann von der Leiterplatte PCB auch der Spannungsabfall über dem Widerstandselement 4 des Strommesswiderstands 1 gemessen werden, um gemäß der Vierleitertechnik den elektrischen Strom zu messen, der durch den Strommesswiderstand 1 fließt.

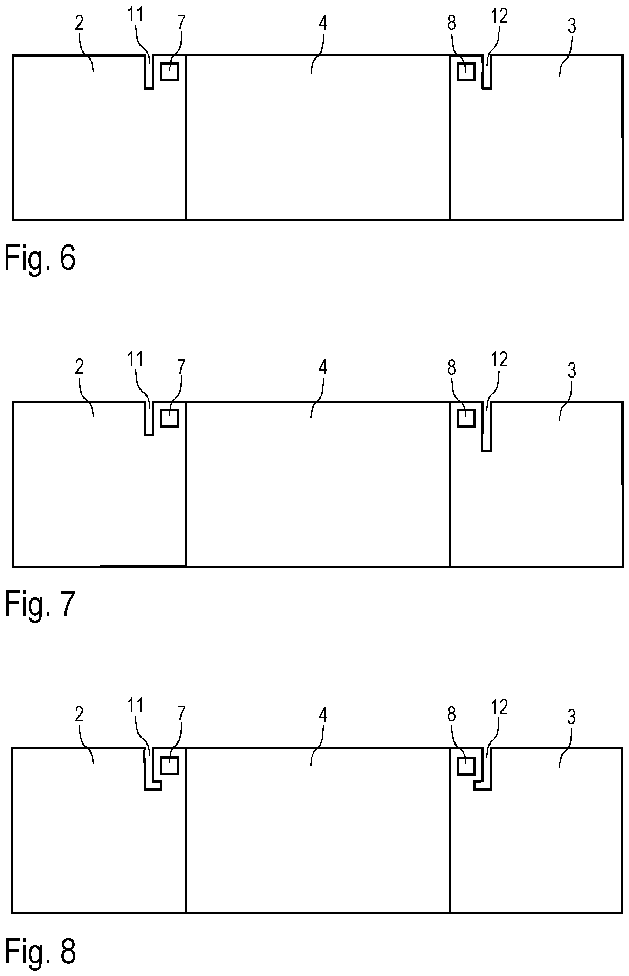

Die Figuren 6-16 zeigen verschiedene schematische Darstellungen eines erfindungsgemäßen Strommesswiderstands 1 in verschiedenen Ausführungsformen, wobei die Darstellung wieder weitgehend mit den eingangs beschriebenen Zeichnungen übereinstimmen, so dass zur Vermeidung von Wiederholungen auf die vorstehende Beschreibung verwiesen wird, wobei für entsprechende Einzelheiten dieselben Bezugszeichen verwendet werden.

So zeigen die Zeichnungen die Spannungsabgriffe 7, 8 in Form von Kontakt-Inseln auf den Anschlussteilen 2 bzw. 3.

Darüber hinaus zeigen die Zeichnungen sogenannte Stromschatten 11, 12 in den Anschlussteilen 2 bzw. 3, wobei die Stromschatten 11, 12 Einschnitte in den Anschlussteilen 2 bzw. 3 sind, die die Aufgabe haben, die Stromverteilung zu beeinflussen.

Die Stromschatten 11, 12 umgeben hier mindestens teilweise die als Kontakt-Inseln ausgebildeten Spannungsabgriffen 7, 8.

Bei dem Ausführungsbeispiel gemäß Figur 6 erstrecken sich die Stromschatten 11, 12 von derselben Seitenkante des Strommesswiderstands 1 nach innen und haben beide dieselbe Länge.

Bei dem Ausführungsbeispiel gemäß Figur 7 ist der Stromschatten 12 in dem Anschlussteil 3 länger als der Stromschatten 11 in dem anderen Anschlussteil 2.

Bei dem Ausführungsbeispiel gemäß Figur 8 sind die beiden Stromschatten 11, 12 jeweils L-förmig und symmetrisch geformt mit der gleichen Größe.

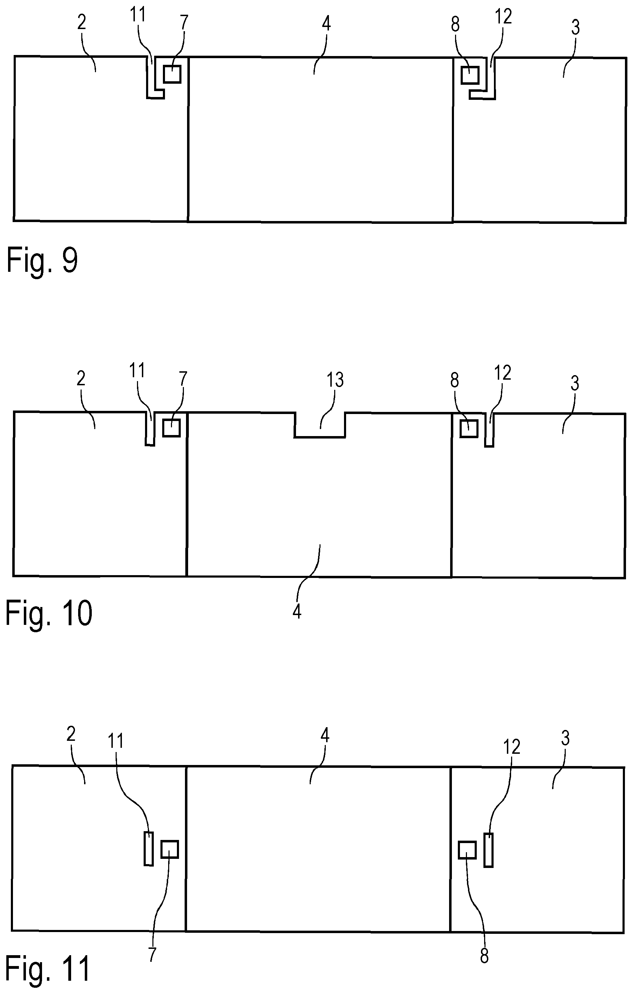

Bei dem Ausführungsbeispiel gemäß Figur 9 ist der L-förmige Stromschatten 12 in dem Anschlussteil 3 länger als der Stromschatten 11 in dem Anschlussteil 2.

Das Ausführungsbeispiel gemäß Figur 10 entspricht im Wesentlichen dem Ausführungsbeispiel gemäß Figur 6. Allerdings befindet sich hierbei in dem Widerstandselement 4 zusätzlich ein Stromschatten 13, der mittig zwischen den beiden Anschlussteilen 2, 3 angeordnet ist und von einer Seitenkante des Strommesswiderstands 1 ausgeht.

Bei dem Ausführungsbeispiel gemäß Figur 11 sind die beiden als Kontakt-Inseln ausgebildeten Spannungsabgriffe 7, 8 in dem Strommesswiderstand 1 mittig zwischen den beiden Seitenkanten angeordnet.

Die beiden Stromschatten 11, 12 befinden sich hierbei in den beiden Anschlussteilen 2, 3 ebenfalls mittig zwischen den beiden Seitenkanten des Strommesswiderstands 1, wobei die beiden Stromschatten 11, 12 hierbei als gerade Schlitze ausgeführt sind.

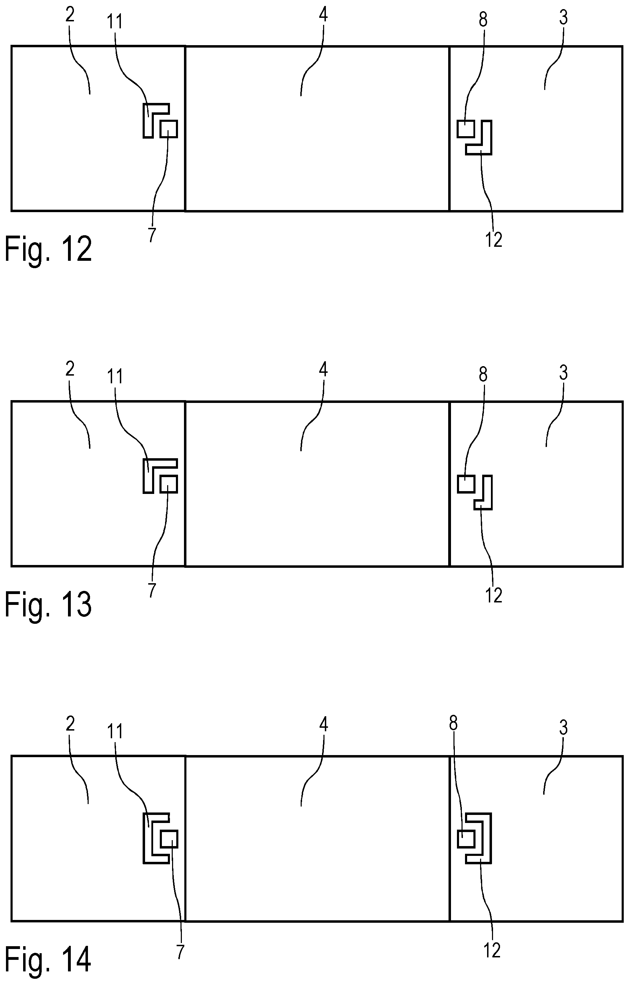

Das Ausführungsbeispiel gemäß Figur 12 entspricht teilweise dem Ausführungsbeispiel gemäß Figur 11. Allerdings sind die beiden Stromschatten 11, 12 hierbei L-förmig und haben dieselbe Größe und Form.

Bei dem Ausführungsbeispiel gemäß Figur 13 sind die beiden Stromschatten 11, 12 ebenfalls L-förmig, jedoch haben die beiden Stromschatten 11, 12 hierbei unterschiedliche Größen.

Figur 14 zeigt eine Abwandlung der Ausführungsbeispiele gemäß den Figuren 11-13, wobei die beiden Stromschatten 11, 12 U-förmig sind.

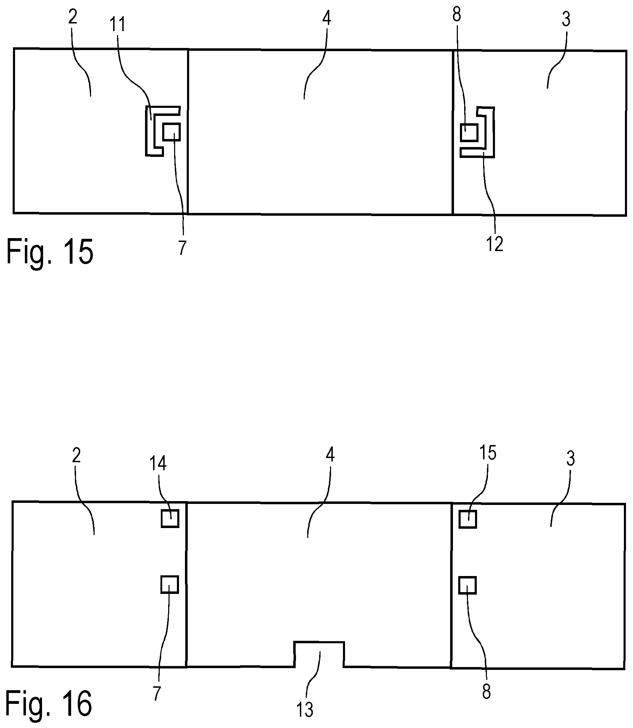

Figur 15 entspricht im Wesentlichen dem Ausführungsbeispiel gemäß Figur 14, wobei die U-förmigen Stromschatten 11, 12 zwei Schenkel mit einer unterschiedlichen Schenkellänge haben.

Figur 16 entspricht weitgehend dem Ausführungsbeispiel gemäß Figur 11, jedoch sind hierbei an den Anschlussteilen 2, 3 zusätzliche Spannungsabgriffe 14, 15 angeordnet. In jedem der beiden Anschlussteile 2, 3 befinden sich also jeweils zwei Spannungsabgriffen 7, 14 bzw. 8, 15. Dies ermöglicht die Messung des Spannungsabfalls an verschiedenen Stellen innerhalb des Strommesswiderstands. Dies bietet den Vorteil, dass Inhomogenitäten der Stromdichteverteilung innerhalb des Strommesswiderstands 1 herausgerechnet werden können.

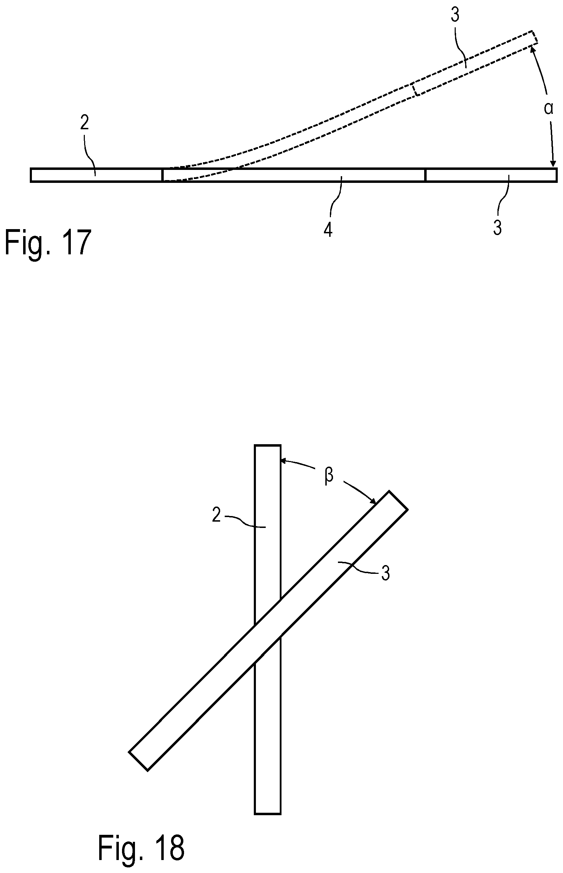

Figur 17 zeigt ein Verformungsszenario eines erfindungsgemäßen Strommesswiderstands 1 mit einem Biegewinkel α. Dies bedeutet, dass die beiden Anschlussteile 2, 3 aufgrund des flexiblen Widerstandselements 4 um den Biegewinkel α relativ zueinander angewinkelt werden können.

Figur 18 zeigt eine schematische Darstellung zur Verformung eines erfindungsgemäßen Strommesswiderstands 1, wobei die beiden Anschlussteile 2, 3 um einen Verdrehwinkel β relativ zueinander verdreht werden können.

### Bezugszeichenliste:

- 1: Strommesswiderstand
- 2, 3: Anschlussteile des Strommesswiderstands
- 4: Widerstandselement des Strommesswiderstands
- 5, 6: Mechanische Verbindungselemente zur Verbindung des Widerstandselements mit den Anschlussteilen
- 7, 8: Spannungsabgriffe
- 9: Leiterbahn auf der Leiterplatte
- 10: Lötverbindung zwischen dem Anschlussteil des Strommesswiderstands und der Leiterbahn bzw. dem Spannungsabgriff der Leiterplatte
- 11, 12: Stromschatten in den Anschlussteilen
- 13: Stromschatten in dem Widerstandselement
- 14, 15: Spannungsabgriffe in den Anschlussteilen des Strommesswiderstands
- PCB: Leiterplatte
- α: Biegewinkel zwischen den Anschlussteilen des Strommesswiderstands
- β: Verdrehwinkel zwischen den Anschlussteilen des Strommesswiderstands

## Patentansprüche

1. Strommesswiderstand (1) zur Messung eines elektrischen Stroms, mit
a) einem ersten Anschlussteil (2) aus einem Leitermaterial und/oder aus einem Widerstandsmaterial zum Einleiten des zu messenden Stroms in den Strommesswiderstand (1),
b) einem zweiten Anschlussteil (3) aus einem Leitermaterial und/oder aus einem Widerstandsmaterial zum Ausleiten des zu messenden Stroms aus dem Strommesswiderstand (1), und
c) einem Widerstandselement (4) aus einem Widerstandsmaterial, wobei das Widerstandselement (4) in Stromflussrichtung zwischen den beiden Anschlussteilen (2, 3) angeordnet ist, so dass der zu messende elektrische Strom bei einer Strommessung durch das Widerstandselement (4) fließt,
d) mindestens einem flexibles Verformungselement (4) zur Ermöglichung einer zerstörungsfreien und reversiblen Verformung des Strommesswiderstands (1), insbesondere zum Ausgleich einer Abstandsänderung oder einer Ausrichtungsänderung zwischen den Anschlussteilen (2, 3) des Strommesswiderstands (1), wobei das Verformungselement (4) in Stromflussrichtung zwischen den beiden Anschlussteilen (2, 3) angeordnet ist, so dass der zu messende elektrische Strom bei der Strommessung durch das Verformungselement (4) fließt, **dadurch gekennzeichnet,**
e) **dass** Verformungselement (4) als Stapel ausgebildet ist.

2. Strommesswiderstand (1) nach Anspruch 1, **dadurch gekennzeichnet,**
a) **dass** das Verformungselement (4) durch das Widerstandselement (4) gebildet wird, und/oder
b) **dass** Verformungselement (4) durch eine der folgenden Verbindungsarten mit mindestens einem der Anschlussteile (2, 3) oder mit mindestens einem der Verbindungselemente verbunden ist:
b1) Pressverbindung,
b2) Schweißverbindung,
b3) Nietverbindung,
b4) Crimp-Verbindung.

3. Strommesswiderstand (1) nach einem der vorhergehenden Ansprüche,
**dadurch gekennzeichnet,**
a) **dass** das Verformungselement (4) elastisch oder plastisch verformbar ist, und/oder
b) **dass** das Verformungselement (4) eine zerstörungsfreie Längenänderung des Strommesswiderstands (1) von mindestens 10%, 20%, 30%, 50% oder 100% ermöglicht, und/oder
c) **dass** das Verformungselement (4) eine zerstörungsfreie Verbiegung der Anschlussteile (2, 3) relativ zueinander von mindestens 10°, 20°, 40°, 80°, 90°, 100°, 135°, 160° oder 180° ermöglicht, und/oder
d) **dass** das Verformungselement (4) eine zerstörungsfreie Verdrehung der Anschlussteile (2, 3) relativ zueinander von mindestens 10°, 20°, 40°, 80° oder 90° ermöglicht.

4. Strommesswiderstand (1) nach einem der vorhergehenden Ansprüche,
**dadurch gekennzeichnet,**
a) **dass** das Verformungselement (4) über mechanische Verbindungselemente (5, 6) jeweils in einem Verbindungsbereich mit den Anschlussteilen (2, 3) verbunden ist,
b) **dass** die Anschlussteile (2, 3) jeweils die Verbindungselemente (5, 6) einschließen, abdecken oder ummanteln, so dass der Verbindungsbereich auch einen elektrischen Kontaktierungsbereich bildet, oder
c) **dass** die Anschlussteile (2, 3) räumlich getrennt von den Verbindungselementen (5, 6) sind, so dass der Verbindungsbereich getrennt von dem Kontaktierungsbereich ist.

5. Strommesswiderstand (1) nach einem der vorhergehenden Ansprüche,
**gekennzeichnet durch**
a) mindestens einen ersten Spannungsabgriff (7) an dem ersten Anschlussteil (2) und/oder an dem Widerstandselement, und
b) mindestens einen zweiten Spannungsabgriff (8) an dem zweiten Anschlussteil (3) und/oder an dem Widerstandselement.

6. Strommesswiderstand (1) nach Anspruch 5, **dadurch gekennzeichnet,**
a) **dass** die Spannungsabgriffe (7, 8) an den Anschlussteilen (2, 3) oder dem Widerstandselement (4) jeweils durch einen Pin gebildet werden,
b) **dass** die Pins (7, 8) optional in Bohrungen in den Anschlussteilen (2, 3) oder dem Widerstandselement (4) eingepresst, auf die Anschlussteile (2, 3) oder das Widerstandselement (4) aufgeschweißt oder auf die Anschlussteile (2, 3) oder das Widerstandselement (4) aufgelötet sind,
c) **dass** die Pins (7, 8) optional aus dem Leitermaterial der Anschlussteile (2, 3) oder aus dem Widerstandsmaterial des Widerstandselements (4) bestehen,
d) **dass** die Pins (7, 8) optional mit einer Beschichtung beschichtet sind, insbesondere mit einer Beschichtung aus Zinn oder Silber.

7. Strommesswiderstand (1) nach einem der vorhergehenden Ansprüche,
**gekennzeichnet durch**
a) einen ersten Stromschatten (11) in Form eines Einschnitts in dem ersten Anschlussteil (2) zur Beeinflussung des Stromverlaufs in dem ersten Anschlussteil (2), wobei der erste Stromschatten (11) vorzugsweise den ersten Spannungsabgriff (7) mindestens teilweise umgibt, und
b) einen zweiten Stromschatten (12) in Form eines Einschnitts in dem zweiten Anschlussteil (3) zur Beeinflussung des Stromverlaufs in dem zweiten Anschlussteil (3), wobei der zweite Stromschatten (12) vorzugsweise den zweiten Spannungsabgriff (8) mindestens teilweise umgibt.

8. Strommesswiderstand (1) nach Anspruch 7, **dadurch gekennzeichnet,**
a) **dass** die beiden Stromschatten (11, 12) in den Anschlussteilen (2, 3) die gleiche Form oder eine unterschiedliche Form haben, und/oder
b) **dass** die beiden Stromschatten (11, 12) in den Anschlussteilen (2, 3) die gleiche oder eine unterschiedliche Länge entlang dem Einschnitt haben, und/oder
c) **dass** die beiden Stromschatten (11, 12) in den Anschlussteilen (2, 3) L-förmig, U-förmig, C-förmig, V-förmig, gerade oder bogenförmig, insbesondere kreisbogenförmig sind, und/oder
d) **dass** die beiden Stromschatten (11, 12) in den Anschlussteilen (2, 3) vom Rand des Strommesswiderstands (1) ausgehen und/oder von dem Rand des Strommesswiderstands (1) beabstandet sind, und/oder
e) **dass** die beiden Stromschatten (11, 12) in den Anschlussteilen (2, 3) denselben Abstand oder unterschiedliche Abstände vom seitlichen Rand des Strommesswiderstands (1) haben.

9. Strommesswiderstand (1) nach einem der vorhergehenden Ansprüche,
**dadurch gekennzeichnet,**
a) **dass** in dem Widerstandselement (4) ein Stromschatten (13) in Form eines Einschnitts angeordnet ist, um den Stromverlauf in dem Widerstandselement (4) zu beeinflussen,
b) **dass** der Stromschatten (13) in dem Widerstandselement (4) optional vom seitlichen Rand, von einer oder von beiden Seiten des Widerstandselements (4) ausgeht,
c) **dass** der Stromschatten (13) in dem Widerstandselement optional mittig zwischen den Anschlussteilen (2, 3) angeordnet ist,
d) **dass** der Stromschatten (13) in mindestens einer oder allen Ebenen eines Stapels, der das Verformungselement bildet, angeordnet ist.

10. Strommesswiderstand (1) nach einem der vorherigen Ansprüche, **dadurch gekennzeichnet,**
a) **dass** in das Widerstandselement (4) und/oder in mindestens eines der Verbindungselemente (5, 6) ein Trimmschnitt eingebracht ist, um den Widerstandswerts zu justieren,
b) **dass** der Trimmschnitt optional durch eines der folgenden Verfahren eingebracht ist:
b1) Stanzen,
b2) Fräsen,
b3) Bohren,
b4) Schleifen,
b5) Lasern.

11. Strommesswiderstand nach Anspruch 10, **dadurch gekennzeichnet, dass** der Trimmschnitt in Widerstandselement und/oder in mindestens einem der Verbindungselements wie folgt angeordnet ist:
a) Seitlich vom Rand von einer oder beiden Seiten ausgehend, und/oder
b) beabstandet zu den Rändern im Inneren des Strommesswiderstands, insbesondere flächig, als Langloch oder als Schlitz,
c) in mindestens einer oder allen Ebenen eines Stapels, der das Verformungselement bildet.

12. Strommesswiderstand (1) nach einem der Ansprüche 5 bis 11, **dadurch gekennzeichnet,**
a) **dass** die Spannungsabgriffe (7, 8) jeweils durch Kontakt-Inseln auf den Anschlussteilen (2, 3) und/oder dem Widerstandselement (4) gebildet werden, oder
b) **dass** die Spannungsabgriffe (7, 8) durch Gegenkontaktierungsflächen gebildet werden, die mit den Anschlussteilen (2, 3) und/oder dem Widerstandselement (4) in Kontakt stehen, wobei sich die Gegenkontaktierungsflächen optional auf einer Leiterplatte (PCB), einem Stecker, einem Pin oder einem Stanzgitter befinden.

13. Strommesswiderstand (1) nach einem der vorhergehenden Ansprüche,
**dadurch gekennzeichnet,**
a) **dass** das Leitermaterial der Anschlussteile (2, 3) Kupfer, eine Kupferlegierung, Aluminium oder eine Aluminiumlegierung ist, und/oder
b) **dass** das Widerstandsmaterial des Widerstandselements (4) eine der folgenden Legierungen ist:
b1) eine Kupfer-Legierung, insbesondere eine Kupfer-Mangan-Zinn-Legierung, insbesondere CuMn12Ni2 oder CuMn7Sn2,3, oder eine Kupfer-Mangan-Nickel-Legierung, insbesondere Cu84Ni4Mn12 oder Cu65Mn25Ni10, oder eine Kupfer-Chrom-Legierung,
b2) eine Nickel-Legierung, insbesondere NiCr, insbesondere NiCr20AlSi oder CuNi, insbesondere CuNi44 und/oder
c) **dass** das Leitermaterial der Anschlussteile (2, 3) einen kleineren spezifischen elektrischen Widerstand aufweist als das Widerstandsmaterial des Widerstandselements (4), und/oder
d) **dass** das Widerstandsmaterial des Widerstandselements (4) einen spezifischen elektrischen Widerstand aufweist, der kleiner ist als 2·10⁻⁴ Ω·m, 2·10⁻⁵ Ω·m oder 2·10⁻⁶ Ω·m, und/oder
e) **dass** das Widerstandsmaterial des Widerstandselements (4) einen spezifischen elektrischen Widerstand aufweist, der größer ist als 2·10⁻⁶ Ω·m oder 2·10⁻⁷ Ω·m, und/oder
f) **dass** das Leitermaterial der Anschlussteile (2, 3) einen spezifischen elektrischen Widerstand aufweist, der kleiner ist als 10⁻⁶ Ω·m oder 10⁻⁷ Ω·m, und/oder
g) **dass** das Widerstandsmaterial des Widerstandselements (4) einen Temperaturkoeffizienten des elektrischen Widerstands von weniger als 50 ppm/K im Temperaturbereich T1 = -20°C bis +140°C bezogen auf eine Referenztemperatur TRef = 20°C aufweist, und/oder
h) **dass** das Widerstandsmaterial des Widerstandselements (4) einen Temperaturkoeffizienten des elektrischen Widerstands von weniger als 60 ppm/K im Temperaturbereich T2 = -40°C bis +200°C bezogen auf eine Referenztemperatur TRef = 20°C aufweist, und/oder
i) **dass** das Widerstandsmaterial des Widerstandselements (4) einen Temperaturkoeffizienten des elektrischen Widerstands von weniger als 80 ppm/K im Temperaturbereich T3 = -60°C bis +200°C bezogen auf die Referenztemperatur TRef = 20°C aufweist, und/oder
j) **dass** die Anschlussteile (2, 3) mit einer Beschichtung beschichtet sind, insbesondere aus Nickel oder einer Nickel-Legierung und/oder Zinn oder einer Zinn-Legierung, und/oder
k) **dass** die Anschlussteile (2, 3) jeweils plattenförmig sind, und/oder
l) dass die Anschlussteile (2, 3) eben oder gebogen sind, und/oder
m) **dass** der Strommesswiderstand (1) einen elektrischen Widerstandswert von höchstens 10 mΩ, 1 mΩ, 100 µΩ oder 10 µΩ aufweist.

14. Messanordnung mit
a) einem Strommesswiderstand (1) nach einem der vorhergehenden Ansprüche, und
b) einem Kontaktierungspartner für den Strommesswiderstand (1), wobei mindestens eines der Anschlussteile (2, 3) des Strommesswiderstands (1) elektrisch und mechanisch mit dem Kontaktierungspartner verbunden ist.

15. Messanordnung nach Anspruch 14, **dadurch gekennzeichnet, dass** der Kontaktierungspartner eine Leiterplatte (PCB), ein Stecker, ein Pin oder ein Stanzgitter ist.

## Claims

1. Current measuring resistor (1) for measuring an electric current, having
a) a first connection part (2) made of a conductor material and/or of a resistor material for introducing the current to be measured into the current measuring resistor (1),
b) a second connection part (3) made of a conductor material and/or of a resistor material for conducting the current to be measured out of the current measuring resistor (1), and
c) a resistor element (4) made of a resistor material, the resistor element (4) being arranged in the direction of current flow between the two connection parts (2, 3), so that the electric current to be measured flows through the resistor element (4) during a current measurement,
d) at least one flexible deformation element (4) for enabling a non-destructive and reversible deformation of the current measuring resistor (1), in particular for compensating for a change in distance or a change in alignment between the connection parts (2, 3) of the current measuring resistor (1), the deformation element (4) being arranged between the two connection parts (2, 3) in the direction of current flow, so that the electric current to be measured flows through the deformation element (4) during the current measurement,
**characterized in**
e) **that** the deformation element (4) is formed as a stack.

2. Current measuring resistor (1) according to claim 1, **characterized in**
a) **that** the deformation element (4) is formed by the resistor element (4), and/or
b) **that** the deformation element (4) is connected to at least one of the connection parts (2, 3) or to at least one of the connection elements by one of the following connection types:
b1) press connection,
b2) welded connection,
b3) riveted connection,
b4) crimp connection.

3. Current measuring resistor (1) according to one of the preceding claims, **characterized in**
a) **that** the deformation element (4) is elastically or plastically deformable, and/or
b) **that** the deformation element (4) allows a non-destructive length change of the current measuring resistor (1) of at least 10%, 20%, 30%, 50% or 100%, and/or
c) **that** the deformation element (4) allows a non-destructive bending of the connection parts (2, 3) relative to each other of at least 10°, 20°, 40°, 80°, 90°, 100°, 135°, 160° or 180°, and/or
d) **that** the deformation element (4) permits non-destructive rotation of the connection parts (2, 3) relative to one another by at least 10°, 20°, 40°, 80° or 90°.

4. Current measuring resistor (1) according to one of the preceding claims, **characterized in**
a) **that** the deformation element (4) is connected to the connection parts (2, 3) via mechanical connection elements (5, 6) in each case in a connecting region,
b) **that** the connection parts (2, 3) each enclose, cover or sheathe the connection elements (5, 6), so that the connecting region also forms an electrical contact region, or
c) **that** the connection parts (2, 3) are spatially separated from the connection elements (5, 6) so that the connecting area is separate from the contact region.

5. Current measuring resistor (1) according to any one of the preceding claims,
**characterized by**
a) at least one first voltage tap (7) on the first connection part (2) and/or on the resistor element, and
b) at least one second voltage tap (8) on the second connection part (3) and/or on the resistor element.

6. Current measuring resistor (1) according to claim 5, **characterized in,**
a) **that** the voltage taps (7, 8) on the connection parts (2, 3) or the resistor element (4) are each formed by a pin,
b) **that** the pins (7, 8) are optionally pressed into bores in the connection parts (2, 3) or the resistor element (4), welded onto the connection parts (2, 3) or the resistor element (4) or soldered onto the connection parts (2, 3) or the resistor element (4),
c) **that** the pins (7, 8) optionally consist of the conductor material of the connection parts (2, 3) or of the resistor material of the resistor element (4),
d) **that** the pins (7, 8) are optionally coated with a coating, in particular with a coating of tin or silver.

7. Current measuring resistor (1) according to any one of the preceding claims,
**characterized by**
a) a first current shadow (11) in the form of an incision in the first connection part (2) for influencing the current flow in the first connection part (2), the first current shadow (11) preferably at least partially surrounding the first voltage tap (7), and
b) a second current shadow (12) in the form of an incision in the second connection part (3) for influencing the current flow in the second connection part (3), the second current shadow (12) preferably at least partially surrounding the second voltage tap (8).

8. Current measuring resistor (1) according to claim 7, **characterized in,**
a) **that** the two current shadows (11, 12) in the connection parts (2, 3) have the same shape or a different shape, and/or
b) **that** the two current shadows (11, 12) in the connection parts (2, 3) have the same or a different length along the incision, and/or
c) **that** the two current shadows (11, 12) in the connection parts (2, 3) are L-shaped, U-shaped, C-shaped, V-shaped, straight or arc-shaped, in particular circular arc-shaped, and/or
d) **that** the two current shadows (11, 12) in the connection parts (2, 3) start from the edge of the current-measuring resistor (1) and/or are spaced apart from the edge of the current-measuring resistor (1), and/or
e) **that** the two current shadows (11, 12) in the connection parts (2, 3) have the same distance or different distances from the lateral edge of the current measuring resistor (1).

9. Current measuring resistor (1) according to one of the preceding claims, **characterized in**
a) **that** a current shadow (13) in the form of an incision is arranged in the resistor element (4) in order to influence the current flow in the resistor element (4),
b) **that** the current shadow (13) in the resistor element (4) optionally emanates from the lateral edge, from one or from both sides of the resistor element (4),
c) **that** the current shadow (13) in the resistor element is optionally arranged centrally between the connection parts (2, 3),
d) **that** the current shadow (13) is arranged in at least one or all planes of a stack forming the deformation element.

10. Current measuring resistor (1) according to one of the previous claims, **characterized in,**
a) **that** a trim cut is introduced into the resistor element (4) and/or into at least one of the connection elements (5, 6) in order to adjust the resistance value,
b) **that** the trim cut is optionally introduced by one of the following processes:
b1) punching,
b2) milling,
b3) drilling,
b4) grinding,
b5) laser cutting.

11. Current measuring resistor according to claim 10, **characterized in that** the trim cut is arranged in the resistor element and/or in at least one of the connection elements as follows:
a) laterally from the edge from one or both sides, and/or
b) at a distance from the edges in the interior of the current-measuring resistor, in particular in a planar manner, as an oblong hole or as a slot,
c) in at least one or all planes of a stack forming the deformation element.

12. Current measuring resistor (1) according to one of claims 5 to 11, **characterized in,**
a) **that** the voltage taps (7, 8) are each formed by contact pads on the connection parts (2, 3) and/or the resistor element (4), or
b) **that** the voltage taps (7, 8) are formed by mating contact surfaces which are in contact with the connection parts (2, 3) and/or the resistor element (4), the mating contact surfaces optionally being located on a printed circuit board (PCB), a plug, a pin or a stamped grid.

13. Current measuring resistor (1) according to one of the preceding claims,
**characterized in**
a) **that** the conductor material of the connection parts (2, 3) is copper, a copper alloy, aluminum or an aluminum alloy, and/or
b) **that** the resistor material of the resistor element (4) is one of the following alloys:
b1) a copper alloy, in particular a copper-manganese-tin alloy, in particular CuMn12Ni2 or CuMn7Sn2,3, or a copper-manganese-nickel alloy, in particular Cu84Ni4Mn12 or Cu65Mn25Ni10, or a copper-chromium alloy,
b2) a nickel alloy, in particular NiCr, in particular NiCr20AlSi or CuNi, in particular CuNi44 and/or
c) **that** the conductor material of the connection parts (2, 3) has a lower specific electrical resistance than the resistor material of the resistor element (4), and/or
d) **that** the resistor material of the resistor element (4) has a specific electrical resistance smaller than 2·10⁻⁴ Ω·m, 2·10⁻⁵ Ω·m or 2·10⁻⁶ Ω·m, and/or
e) **that** the resistive material of the resistor element (4) has a specific electrical resistance greater than 2·10⁻⁶ Ω·m or 2·10⁻⁷ Ω·m, and/or
f) **that** the conductor material of the connection parts (2, 3) has a specific electrical resistance which is smaller than 10⁻⁶ Ω·m or 10⁻⁷ Ω·m, and/or
g) **that** the resistor material of the resistor element (4) has a temperature coefficient of electrical resistance of less than 50 ppm/K in the temperature range T1 = -20°C to +140°C relative to a reference temperature TRef = 20°C, and/or
h) **that** the resistor material of the resistor element (4) has a temperature coefficient of electrical resistance of less than 60 ppm/K in the temperature range T2 = -40°C to +200°C referred to a reference temperature TRef = 20°C, and/or
i) **that** the resistor material of the resistor element (4) has a temperature coefficient of electrical resistance of less than 80 ppm/K in the temperature range T3 = -60°C to +200°C referred to the reference temperature TRef = 20°C, and/or
j) **that** the connection parts (2, 3) are coated with a coating, in particular of nickel or a nickel alloy and/or tin or a tin alloy, and/or
k) **that** the connection parts (2, 3) are each plate-shaped, and/or
l) that the connection parts (2, 3) are flat or bent, and/or
m) **that** the current measuring resistor (1) has an electrical resistance value of at most 10 mΩ, 1 mΩ, 100 µΩ or 10 µΩ.

14. Measuring arrangement with
a) a current measuring resistor (1) according to one of the preceding claims, and
b) a contacting partner for the current measuring resistor (1), wherein at least one of the connection parts (2, 3) of the current measuring resistor (1) is electrically and mechanically connected to the contacting partner.

15. Measuring arrangement according to claim 14, **characterized in that** the contacting partner is a printed circuit board (PCB), a connector, a pin or a stamped grid.

## Revendications

1. Résistance de mesure de courant (1) pour la mesure d'un courant électrique, avec
a) une première pièce de raccordement (2) en un matériau conducteur et/ou en un matériau résistif pour introduire le courant à mesurer dans la résistance de mesure de courant (1),
b) une deuxième pièce de raccordement (3) en un matériau conducteur et/ou en un matériau résistif pour faire sortir le courant à mesurer de la résistance de mesure de courant (1), et
c) un élément résistif (4) en un matériau résistif, dans laquelle l'élément résistif (4) est disposé dans le sens du flux de courant entre les deux pièces de raccordement (2, 3) de sorte que le courant électrique à mesurer circule à travers l'élément résistif (4) lors d'une mesure de courant,
d) au moins un élément de déformation (4) flexible pour permettre une déformation non destructive et réversible de la résistance de mesure de courant (1), en particulier pour compenser une modification de distance ou une modification d'orientation entre les pièces de raccordement (2, 3) de la résistance de mesure de courant (1), dans laquelle l'élément de déformation (4) est disposé dans le sens du flux de courant entre les deux pièces de raccordement (2, 3) de sorte que le courant électrique à mesurer lors de la mesure de courant circule à travers l'élément de déformation (4),
**caractérisée en ce**
e) **que** l'élément de déformation (4) est réalisé comme un empilement.

2. Résistance de mesure de courant (1) selon la revendication 1, **caractérisée en ce**
a) **que** l'élément de déformation (4) est formé par l'élément résistif (4), et/ou
b) **que** l'élément de déformation (4) est relié à au moins l'une des pièces de raccordement (2, 3) ou à au moins l'un des éléments de liaison par l'un des types de liaison suivants :
b1) liaison serrée,
b2) liaison soudée,
b3) liaison rivetée,
b4) liaison sertie.

3. Résistance de mesure de courant (1) selon l'une quelconque des revendications précédentes,
**caractérisée en ce**
a) **que** l'élément de déformation (4) est déformable élastiquement ou plastiquement, et/ou
b) **que** l'élément de déformation (4) permet une modification de longueur non destructive de la résistance de mesure de courant (1) d'au moins 10 %, 20 %, 30 %, 50 % ou 100 %, et/ou
c) **que** l'élément de déformation (4) présente une flexion non destructive des pièces de raccordement (2, 3) l'une par rapport à l'autre d'au moins 10°, 20°, 40°, 80°, 90°, 100°, 135°, 160° ou 180°, et/ou
d) **que** l'élément de déformation (4) permet une rotation non destructive des pièces de raccordement (2, 3) l'une par rapport à l'autre d'au moins 10°, 20°, 40°, 80° ou 90°.

4. Résistance de mesure de courant (1) selon l'une quelconque des revendications précédentes,
**caractérisée en ce**
a) **que** l'élément de déformation (4) est relié aux pièces de raccordement (2, 3) par des éléments de liaison mécaniques (5, 6) respectivement dans une zone de liaison,
b) **que** les pièces de raccordement (2, 3) englobent, recouvrent ou enveloppent respectivement les éléments de liaison (5, 6) de sorte que la zone de liaison forme également une zone de mise en contact électrique, ou
c) **que** les pièces de raccordement (2, 3) sont séparées dans l'espace des éléments de liaison (5, 6) de sorte que la zone de liaison est séparée de la zone de mise en contact.

5. Résistance de mesure de courant (1) selon l'une quelconque des revendications précédentes, **caractérisée par**
a) au moins une première prise de tension (7) sur la première pièce de raccordement (2) et/ou sur l'élément résistif, et
b) au moins une deuxième prise de tension (8) sur la deuxième pièce de raccordement (3) et/ou sur l'élément résistif.

6. Résistance de mesure de courant (1) selon la revendication 5, **caractérisée en ce**
a) **que** les prises de tension (7, 8) sur les pièces de raccordement (2, 3) ou l'élément résistif (4) sont formées respectivement par une broche,
b) **que** les broches (7, 8) sont facultativement emmanchées dans des alésages dans les pièces de raccordement (2, 3) ou l'élément résistif (4), soudées sur les pièces de raccordement (2, 3) ou l'élément résistif (4) ou brasées sur les pièces de raccordement (2, 3) ou l'élément résistif (4),
c) **que** les broches (7, 8) sont facultativement constituées du matériau conducteur des pièces de raccordement (2, 3) ou du matériau résistif de l'élément résistif (4),
d) **que** les broches (7, 8) sont facultativement revêtues d'un revêtement, en particulier d'un revêtement en étain ou en argent.

7. Résistance de mesure de courant (1) selon l'une quelconque des revendications précédentes, **caractérisée par**
a) une première ombre de courant (11) sous forme d'une entaille dans la première pièce de raccordement (2) pour influencer le cheminement du courant dans la première pièce de raccordement (2), dans laquelle la première ombre de courant (11) entoure de préférence au moins partiellement la première prise de tension (7), et
b) une deuxième ombre de courant (12) sous forme d'une entaille dans la deuxième pièce de raccordement (3) pour influencer le cheminement du courant dans la deuxième pièce de raccordement (3), dans laquelle la deuxième ombre de courant (12) entoure de préférence au moins partiellement la deuxième prise de tension (8).

8. Résistance de mesure de courant (1) selon la revendication 7, **caractérisée en ce**
a) **que** les deux ombres de courant (11, 12) dans les pièces de raccordement (2, 3) ont la même forme ou une forme différente, et/ou
b) **que** les deux ombres de courant (11, 12) dans les pièces de raccordement (2, 3) ont la même longueur ou une longueur différente le long de l'entaille, et/ou
c) **que** les deux ombres de courant (11, 12) dans les pièces de raccordement (2, 3) sont en forme de L, en forme de U, en forme de C, en forme de V, droites ou courbes, en particulier circulaires, et/ou
d) **que** les deux ombres de courant (11, 12) dans les pièces de raccordement (2, 3) partent du bord de la résistance de mesure de courant (1) et/ou sont espacées du bord de la résistance de mesure de courant (1), et/ou
e) **que** les deux ombres de courant (11, 12) dans les pièces de raccordement (2, 3) ont la même distance ou des distances différentes par rapport au bord latéral de la résistance de mesure de courant (1).

9. Résistance de mesure de courant (1) selon l'une quelconque des revendications précédentes, **caractérisée en ce**
a) **qu'**une ombre de courant (13) sous la forme d'une entaille est disposée dans l'élément résistif (4) pour influencer le cheminement du courant dans l'élément résistif (4),
b) **que** l'ombre de courant (13) dans l'élément résistif (4) part facultativement du bord latéral, d'un côté ou des deux côtés de l'élément résistif (4),
c) **que** l'ombre de courant (13) dans l'élément résistif est disposée facultativement au centre entre les pièces de raccordement (2, 3),
d) **que** l'ombre de courant (13) est disposée dans au moins un ou tous les plans d'un empilement qui forme l'élément de déformation.

10. Résistance de mesure de courant (1) selon l'une quelconque des revendications précédentes, **caractérisée en ce**
a) **qu'**une découpe d'ajustement est ménagée dans l'élément résistif (4) et/ou dans au moins l'un des éléments de liaison (5, 6) pour ajuster la valeur de résistance,
b) **que** la découpe d'ajustement est insérée facultativement par l'un des procédés suivants :
b1) poinçonnage,
b2) fraisage,
b3) perçage,
b4) ponçage,
b5) laser.

11. Résistance de mesure de courant selon la revendication 10, **caractérisée en ce que** la découpe d'ajustement est disposée dans l'élément résistif et/ou dans au moins l'un des éléments de liaison comme suit :
a) en partant latéralement du bord d'un ou des deux côtés, et/ou
b) de manière éloignée des bords à l'intérieur de la résistance de mesure de courant, en particulier à plat, en tant que trou oblong ou en tant que fente,
c) dans au moins un ou tous les plans d'un empilement qui forme l'élément de déformation.

12. Résistance de mesure de courant (1) selon l'une quelconque des revendications 5 à 11, **caractérisée en ce**
a) **que** les prises de tension (7, 8) sont formées respectivement par des îlots de contact sur les pièces de raccordement (2, 3) et/ou l'élément résistif (4), ou
b) **que** les prises de tension (7, 8) sont formées par des surfaces de mise en contact homologues qui sont en contact avec les pièces de raccordement (2, 3) et/ou l'élément résistif (4), dans laquelle les surfaces de mise en contact homologues se trouvent facultativement sur une carte de circuits imprimés (PCB), un connecteur, une broche ou une grille de connexion.

13. Résistance de mesure de courant (1) selon l'une quelconque des revendications précédentes, **caractérisée en ce**
a) **que** le matériau conducteur des pièces de raccordement (2, 3) est du cuivre, un alliage de cuivre, de l'aluminium ou un alliage d'aluminium, et/ou
b) **que** le matériau résistif de l'élément résistif (4) est l'un des alliages suivants :
b1) un alliage de cuivre, en particulier un alliage cuivre-manganèse-nickel, en particulier CuMn12Ni2 ou CuMn7Sn2,3, ou un alliage cuivre-manganèse-nickel, en particulier Cu84Ni4Mn12 ou Cu65Mn25Ni10, ou un alliage cuivre-chrome,
b2) un alliage de nickel, en particulier NiCr, en particulier NiCr20AISi ou CuNi, en particulier CuNi44 et/ou
c) **que** le matériau conducteur des pièces de raccordement (2, 3) présente une résistance électrique spécifique plus petite que le matériau résistif de l'élément résistif (4), et/ou
d) **que** le matériau résistif de l'élément résistif (4) présente une résistance électrique spécifique qui est inférieure à 2·10⁻⁴ **Ω** ·m, 2·10⁻⁵ **Ω**·m ou 2·10⁻⁶ **Ω**·m, et/ou
e) **que** le matériau résistif de l'élément résistif (4) présente une résistance électrique spécifique qui est supérieure à 2·10⁻⁶ **Ω**·m ou 2·10⁻⁷ **Ω**·m, et/ou
f) **que** le matériau conducteur des pièces de raccordement (2, 3) présente une résistance électrique spécifique qui est inférieure à 10⁻⁶ **Ω**·m ou 10⁻⁷ **Ω**·m, et/ou
g) **que** le matériau résistif de l'élément résistif (4) présente un coefficient de température de la résistance électrique inférieur à 50 ppm/K dans la plage de température T1 = -20 °C à +140 °C par rapport à une température de référence TRef = 20 °C, et/ou
h) **que** le matériau résistif de l'élément résistif (4) présente un coefficient de température de la résistance électrique inférieur à 60 ppm/K dans la plage de température T2 = -40 °C à +200 °C par rapport à une température de référence TRef = 20 °C, et/ou
i) **que** le matériau résistif de l'élément résistif (4) présente un coefficient de température de la résistance électrique inférieur à 80 ppm/K dans la plage de température T3 = -60 °C à +200 °C par rapport à la température de référence TRef = 20 °C, et/ou
j) **que** les pièces de raccordement (2, 3) sont revêtues d'un revêtement, en particulier en nickel ou en un alliage de nickel et/ou en étain ou en un alliage d'étain, et/ou
k) **que** les pièces de raccordement (2, 3) sont respectivement en forme de plaque, et/ou
l) que les pièces de raccordement (2, 3) sont planes ou courbées, et/ou
m) **que** la résistance de mesure de courant (1) présente une valeur de résistance électrique de maximum 10 m**Ω**, 1 m**Ω**, 100 µ**Ω** ou 10 µ**Ω**.

14. Ensemble de mesure avec
a) une résistance de mesure de courant (1) selon l'une quelconque des revendications précédentes, et
b) un partenaire de mise en contact pour la résistance de mesure de courant (1), dans lequel au moins l'une des pièces de raccordement (2, 3) de la résistance de mesure de courant (1) est reliée électriquement et mécaniquement au partenaire de mise en contact.

15. Ensemble de mesure selon la revendication 14, **caractérisé en ce que** le partenaire de mise en contact est une carte de circuit imprimé (PCB), un connecteur, une broche ou une grille de connexion.
